# EUROPEAN PATENT SPECIFICATION

(11) **EP 3 726 227 B1**
(45) Date of publication and mention of the grant of the patent: **04.05.2022**
(21) Application number: 18887315.2
(22) Date of filing: 11.12.2018
(51) Int. Cl.: G01R 15/20, G01R 3/00, G01R 19/00

(54) **CURRENT SENSOR**
STROMSENSOR
CAPTEUR DE COURANT

(30) Priority: 13.12.2017 JP 2017238461
(43) Date of publication of application: 21.10.2020
(73) Proprietor: Alps Alpine Co., Ltd., Ota-ku Tokyo 145-8501 (JP)
(72) Inventor: TAMURA, Manabu, Tokyo 145-8501 (JP); YAMAMOTO, Naoki, Tokyo 145-8501 (JP)
(74) Representative: Schmitt-Nilson Schraud Waibel Wohlfrom Patentanwälte Partnerschaft mbB
(86) International application number: PCT/JP2018/045570
(87) International publication number: WO 2019/117169

(56) References cited:
- JP-A- 2007 171 156
- JP-A- 2010 181 184
- JP-A- 2011 133 314
- JP-A- 2012 122 793
- JP-A- 2012 242 176
- JP-A- 2012 242 176
- JP-A- 2014 092 478
- JP-A- 2016 031 293
- JP-A- 2017 026 392
- JP-A- 2017 102 022
- JP-A- 2017 102 022

## Description

### Technical Field

The present invention relates to a current sensor that measures a current according to a magnetic field generated by the to-be-measured current flowing in a conductor.

### Background Art

As a current sensor that measures to-be-measured currents flowing in multi-phase conductors, a current sensor is known that has a plurality of magnetic sensors that detect a magnetic field for each conductor in the relevant phase. In each magnetic sensor, measurement precision is increased by covering the conductors with a magnetic shield for each phase to shut off external magnetic fields including an induced magnetic field generated by an adjacent conductor.

When conductors are covered with a magnetic shield for each phase in this type of current sensor for multi-phase conductors, to stabilize measurement precision in the current sensor, the magnetic shield needs to be precisely positioned with respect to the conductor.

This type of magnetic shield is known that is positioned with respect to a conductor (bus bar) by being incorporated into the case of the current sensor when the case is assembled (see PTL 1 below). With the structure, however, the fixing of the magnetic shield is insufficient. Therefore, there is the fear that when vibration or the like is given from the external, positional deviation is generated and thereby measurement precision is lowered.

Therefore, a current sensor is known in which, by insert molding the magnetic shield in the lid portion of the case of the current sensor, the lid portion and magnetic shield are integrated together and the magnetic shield is positioned with respect to the conductor (bus bar) (see PTL 2 below) . [insert page 2a]

### Citation List

### Patent Literature

PTL 1: Japanese Unexamined Patent Application Publication No. 2015-145838
PTL 2: Japanese Unexamined Patent Application Publication No. 2017-102022

### Summary of Invention

### Technical Problem

In the current sensor described in PTL 2, a structure is used in which a pressing member is brought into contact between mutual adjacent magnetic shields during insert molding to press both magnetic shields between the mutual adjacent magnetic shields.

According to the structure, a space used to have the pressing member abut between adjacent magnetic shields JP 2011 133314 A discloses a current sensor which includes a bus bar for conducting a current, a hall element for measuring a value of the current flowing through the bus bar, a shield member disposed so as to enclose the bus bar and the hall element, and a resin case to which the bus bar and the shield member are fixed.

JP 2012 242176 A discloses a current sensor that detects, for example, a motor drive current or a battery current by using a magnetic-electric conversion element such as a Hall element. during insert molding needs to be secured, so the interval between the magnetic shields becomes relatively large. Therefore, although no problem occurs when the current sensor is a large current sensor, the necessity for downsizing may occur depending on the specifications of a device in which the current sensor is installed.

Therefore, it can be thought that the current sensor is downsized by reducing the size of the magnetic shield. However, there is the fear that if the size of the magnetic shield is reduced, the current sensor becomes likely to be affected by an external magnetic field because the magnetic sensor cannot be covered with a sufficient breadth and measurement precision is thereby lowered.

The present invention is made in view of the above situation. An object of the present invention is to provide a current sensor that can be downsized without lowering measurement precision.

### Solution to Problem

To achieve the above object, a current sensor of the present invention is characterized by having: a plurality of bus bars formed from an electric conductor; a plurality of magnetic sensors that detect an induced magnetic field generated by a current flowing in each bus bar; a circuit board on which the magnetic sensors are mounted; a case made of a synthetic resin, the case fixing the bus bars and circuit board; a lid portion made of a synthetic resin, the lid portion housing the circuit board together with the case; and a magnetic shield that is insert-molded in the lid portion. The current sensor is further characterized in that the magnetic shield has a plurality of cutouts along its circumferential edges and that hole portions are formed from which the outer edges of the cutouts of the magnetic shield are exposed.

According to the present invention, when the magnetic shield is insert-molded in the lid portion, the magnetic shield can be fixed by, for example, making pressing portions formed in a mold abut the cutouts of the magnetic shield. Due to this, the distance between adjacent magnetic shields can be shortened, so downsizing is possible when compared with the past.

Also, in the current sensor of the present invention, the magnetic shield preferably has four edges oriented in different directions spaced at intervals of 90 degrees, and the cutouts are preferably provided at the four corners of the magnetic shield. Due to the structure, the shape of the magnetic shield of the present invention becomes a rectangular shape in plan view. Since cutouts are provided at the four corners of the magnetic shield in a rectangular shape in plan view, when the magnetic shield is insert-molded in the lid portion, the magnetic shield can be surely positioned by, for example, making a jig abut each cutout. Therefore, precision in molding is improved.

At this time, the cutout is preferably formed in a quadrangular shape in plan view, the magnetic shield is preferably formed in a cross shape in plan view due to four protrusion portions, each of which is a portion between adjacent cutouts, and two protrusion portions positioned on one straight line preferably protrude along the current direction of the bus bar.

Since the cutout is formed in a quadrangular shape in plan view, when the magnetic shield is insert-molded in the lid portion, a jig, for example, can be made to abut the outer edges, which intersect at right angles, of the cutout at each of the four corners of the magnetic shield, so positioning precision of the magnetic shield is further improved. Also, as for the magnetic shield in a cross shape in plan view, since two protrusion portions positioned on one straight line protrude along the current direction of the bus bar, it is hard for a magnetic flux passing in the magnetic shield so as to be orthogonal to the current direction of the bus bar to bend, so high measurement precision can be obtained.

Furthermore, in the magnetic shield, a plurality of plate-like magnetic bodies are preferably stacked in the thickness direction and are preferably linked integrally by caulking portions. In the magnetic shield formed in a cross shape in plan view, the caulking portions are preferably provided in the protrusion portions protruding along the current direction of the bus bar.

A magnetic flux passing in the magnetic shield so as to be orthogonal to the current direction of the bus bar concentrates at a portion with a long length in a direction in which the magnetic flux passes. Since the magnetic shield has a cross shape in plan view, a magnetic flux passing through the protrusion portions protruding along the current direction of the bus bar is relatively small. By forming the caulking portions at positions at which the magnetic flux is small, magnetic flux disturbance caused at the caulking portions is also lessened. Therefore, the effect of magnetic flux disturbance at the caulking portions can be lessened, making it possible to suppress a drop in measurement precision.

Also, in the current sensor of the present invention, a partial surface of the magnetic shield, the partial surface being along the cutout, is preferably exposed. According to this structure, when the magnetic shield is insert-molded, a flow of a resin into a spacing between a mold and the outer edges of the cutout of the magnetic shield is prevented, so generation of burrs can be prevented. Therefore, it is possible to prevent a problem such as the one that burrs come off and become foreign matter.

### Advantageous Effects of Invention

According to the present invention, since, in a current sensor, a magnetic shield having cutouts is insert-molded in a lid portion, downsizing can be made possible without lowering measurement precision.

### Brief Description of Drawings

[Fig. 1] Fig. 1 is a perspective view indicating the outside shape of a current sensor, which is an example of an embodiment of the present invention.
[Fig. 2] Fig. 2 is an explanatory plan view indicating a state in which a lid portion is removed to expose a circuit board.
[Fig. 3] Fig. 3 is a cross-sectional view along line III-III in Fig. 1.
[Fig. 4] Fig. 4 is an explanatory diagram schematically indicating a positional relationship between a magnetic sensor and a magnetic shield in plan view with respect to a bus bar.
[Fig. 5] Fig. 5 is a perspective view indicating the outside shape of the magnetic shield.
[Fig. 6] Fig. 6 is an explanatory cross-sectional view indicating an outline of molds in an injection molding process for the lid portion.
[Fig. 7] Fig. 7 is a perspective view indicating the inner surface of the lid portion.

### Description of Embodiments

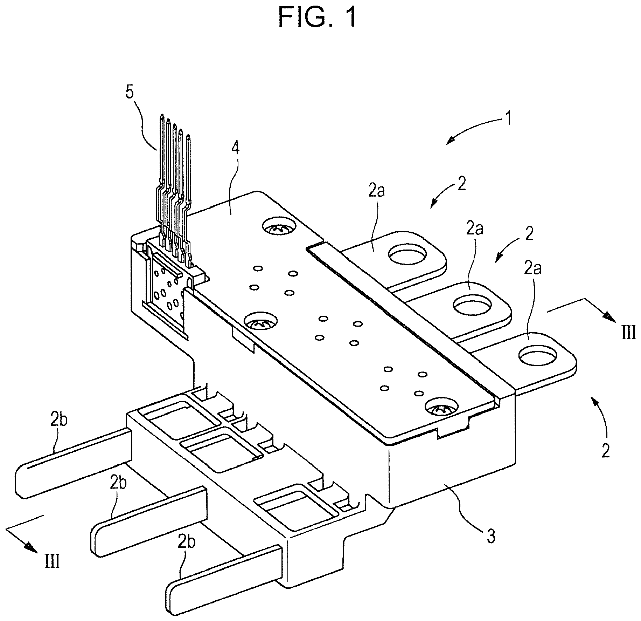

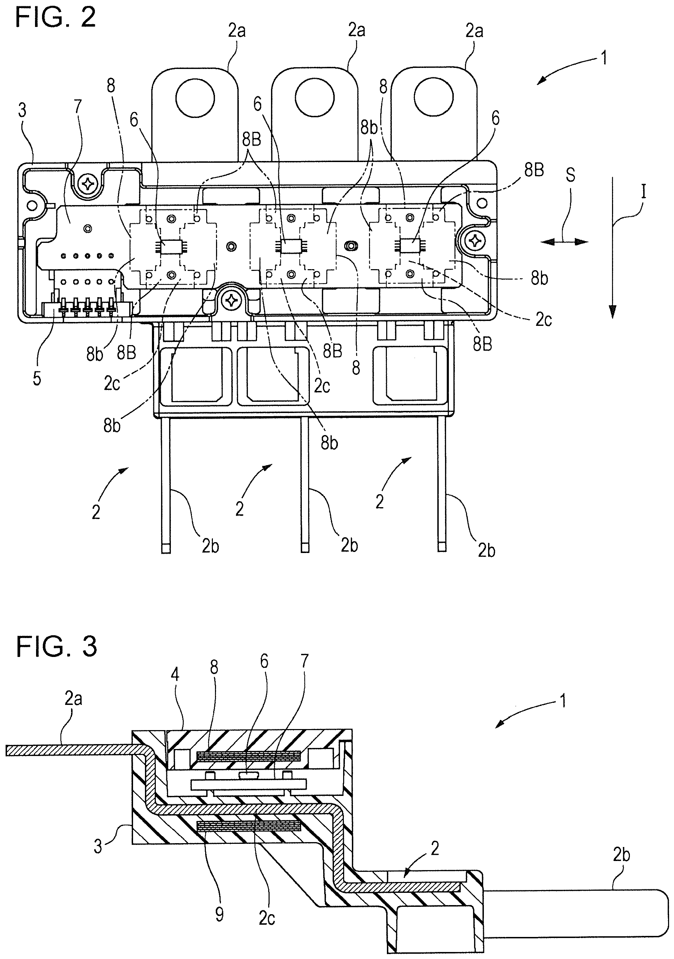

A current sensor 1, which is an example of an embodiment of the present invention will be described with reference to Fig. 1 to Fig. 7. Fig. 1 is a perspective view indicating the outside shape of the current sensor 1 in this embodiment. Fig. 2 is an explanatory plan view indicating a state in which a lid portion 4 of the current sensor 1 in Fig. 1 is removed to expose a circuit board 7. Fig. 3 is a cross-sectional view along line III-III in Fig. 1.

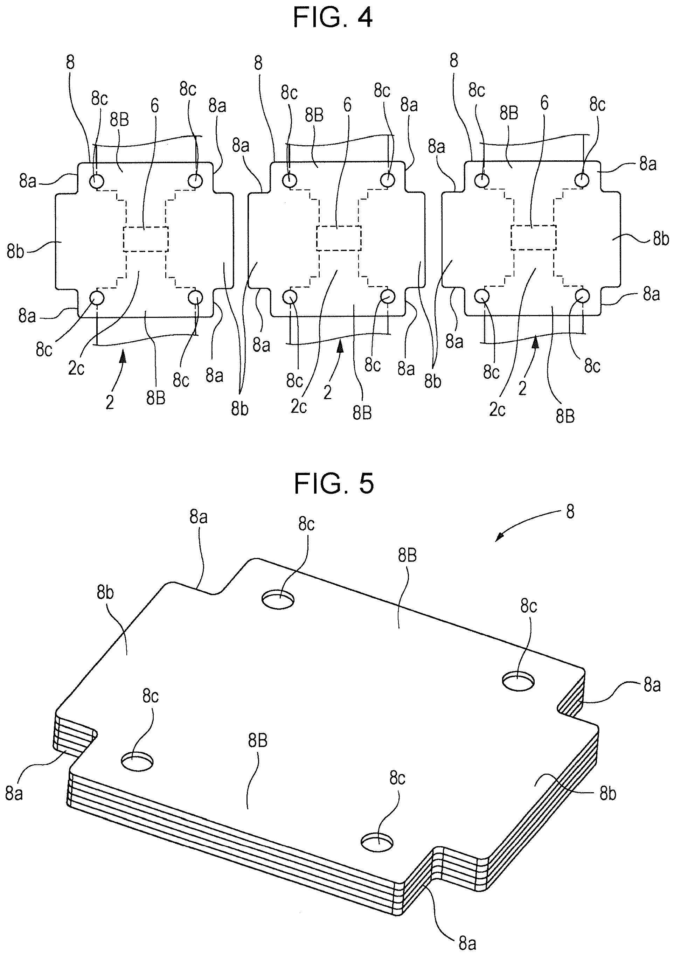

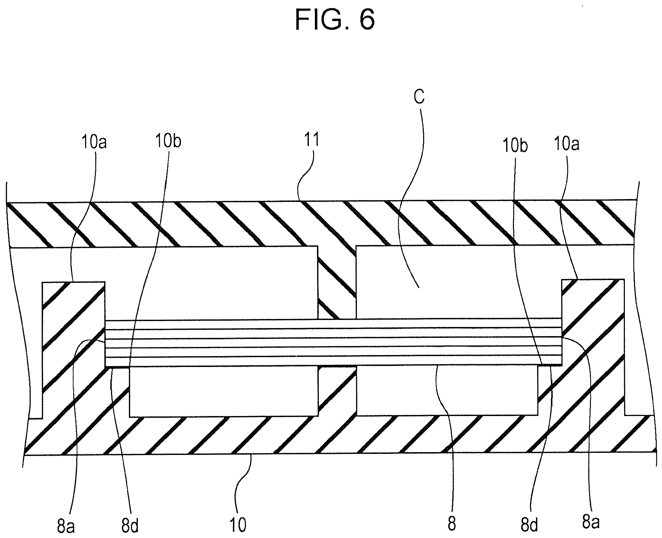

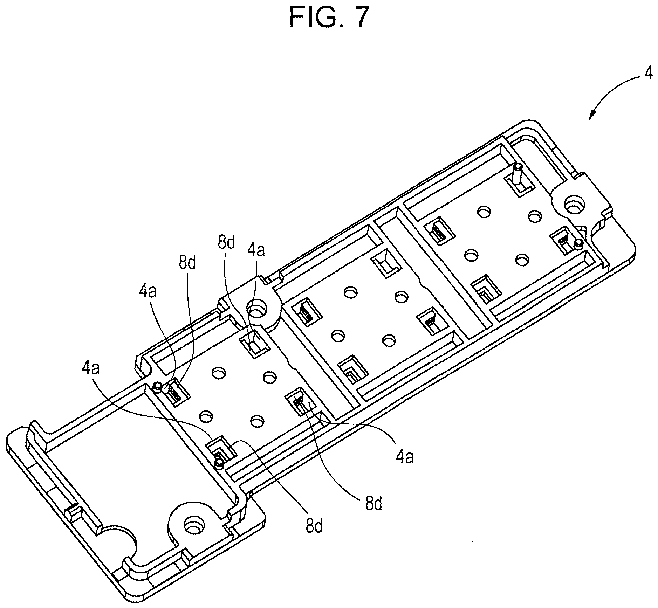

Fig. 4 is an explanatory diagram schematically indicating a positional relationship between a magnetic sensor 6 and a lid-portion magnetic shield 8 in plan view with respect to a bus bar 2. Fig. 5 is a perspective view indicating the outside shape of the lid-portion magnetic shield 8. Fig. 6 is an explanatory cross-sectional view indicating an outline of molds in an injection molding process for the lid portion 4. Fig. 7 is a perspective view indicating the inner surface of the lid portion 4.

As indicated in Fig. 1, the current sensor 1 in this embodiment has: three bus bars 2 formed from a metal as electric conductors (input-side terminals 2a and output-side terminals 2b); a case 3 in a box shape, in which part of the bus bars 2 is accommodated, one side surface (upper surface in the drawing) being open; and a lid portion 4 that closes the open surface (upper surface in the drawing) of the case 3. This lid portion 4 houses a circuit board 7, which will be described later, together with the case 3. Incidentally, a member indicated by reference numeral 5 is a connector extending from the circuit board 7, on which magnetic sensors 6, which will be described later, are mounted.

The bus bar 2 is integrally held by the case 3 with an intermediate portion 2c buried in the case 3 made of a synthetic resin, the intermediate portion 2c extending between the input-side terminals 2a and the output-side terminals 2b, as indicated in Fig. 2. On the bus bar 2, the intermediate portion 2c is at a current detection position at which a current is detected by the magnetic sensor 6. In the intermediate portion 2c, a direction from the input-side terminals 2a to the output-side terminals 2b is a current direction (the arrow I in Fig. 2).

The circuit board 7 is attached and fixed to the inside of the case 3 at a position at which the circuit board 7 overlaps the bus bars 2 with a predetermined spacing, as indicated in Fig. 3. Three magnetic sensors 6 are mounted on the circuit board 7 in correspondence to each bus bar 2, as indicated in Fig. 2. The magnetic sensor 6 is a sensor that measures an induced magnetic field generated from the bus bar 2. The magnetic sensor 6 is disposed so that its magnetosensitive surface faces one side surface of the bus bar 2.

Also, the magnetic sensor 6 is placed so that a sensitivity direction S is orthogonal to a current direction I of the bus bar 2, as indicated in Fig. 2. In addition to a magnetoresistance effect element, other types of elements such as a hall element may be used as the magnetic sensor 6.

The lid-portion magnetic shield 8 is integrally formed in the lid portion 4 by insert molding and is buried, as indicated in Fig. 3. The lid-portion magnetic shield 8 has a rectangular shape in plan view (shape having four edges oriented in different directions spaced at intervals of 90 degrees), around which cutouts 8a are formed at the four corners of the circumferential edges, as indicated in Fig. 4. Since the cutout 8a has a quadrangular shape (to be accurate, a pair of edges adjacent at one corner of the quadrangle) in plan view, the lid-portion magnetic shield 8 has four protrusion portions 8B, 8B, 8b, and 8b between adjacent cutouts 8a.

Since, in the lid-portion magnetic shield 8, the four protrusion portions 8B, 8B, 8b, and 8b are formed by portions between the cutouts 8a at the four corners as indicated in Fig. 4, the lid-portion magnetic shield 8 has a cross shape in plan view. The lid-portion magnetic shield 8 is buried in the lid portion 4 so as to be placed in an orientation in which the two protrusion portions 8B and 8B positioned on one straight line protrude along the current direction I of the bus bar 2 and the two protrusion portions 8b and 8b positioned on the other straight line protrude along a direction orthogonal to the current direction I of the bus bar 2, as indicated in Fig. 2.

Also, the lid-portion magnetic shield 8 is formed so that the length along the direction orthogonal to the current direction I of the bus bar 2 is longer than the length along the current direction I of the bus bar 2.

In the lid-portion magnetic shield 8, a plurality of metal plates (plate-like magnetic bodies) are stacked in the thickness direction and are integrally linked by caulking portions 8c having a crushed recess formed by caulking, as indicated in Fig. 5.

The caulking portion 8c is formed in each of the two protrusion portions 8B and 8B, which protrude along the current direction I of the bus bar 2 when the lid portion 4 is attached to the case 3, as indicated in Fig. 4. Since a magnetic flux concentrates at portions at which the length of the lid-portion magnetic shield 8 is large (protrusion portions 8b and 8b), a magnetic flux flowing in the caulking portions 8c formed at the two protrusion portions 8B and 8B protruding along the current direction I of the bus bar 2 is small. Although there is the fear that the magnetic flux is disturbed at the caulking portion 8c, since the magnetic flux flowing in the caulking portions 8c is small, it is possible to suppress degradation in measurement precision due to the formation of the caulking portions 8c.

The lid portion 4 is formed by injection molding of a synthetic resin material. When the lid portion 4 is injection-molded, the lid-portion magnetic shield 8 is sandwiched between a first mold 10 (mold on the lower side in Fig. 6) and a second mold 11 (mold on the upper side in Fig. 6) and is held in a mold space C as indicated in Fig. 6. The first mold 10 has pressing portions 10a that abut the outer edges of the cutouts 8a at the four corners of the lid-portion magnetic shield 8.

Since the lid-portion magnetic shield 8 has cutouts 8a at its four corners, it suffices to provide the first mold 10 with the pressing portions 10a that abut each cutout 8a. There is no need to provide a pressing portion that abuts throughout the length of the side edge of the lid-portion magnetic shield 8 as is done, for example, in the past. Due to this, the pressing portion 10a of the first mold 10 becomes extremely small, so the distance between mutually adjacent lid-portion magnetic shields 8 can be shortened accordingly and downsizing is possible.

In the conventional current sensor, for example, the distance between adjacent magnetic shields could not be reduced to 5 mm or less. According to the current sensor 1 in this embodiment, however, the distance between the lid-portion magnetic shields 8 can be reduced to about 0.5 to 3.0 mm. Incidentally, if the distance between the lid-portion magnetic shields 8 is reduced too much, this is not preferable because the magnetic capacity of the lid-portion magnetic shield 8 is likely to be saturated.

Also, since the lid-portion magnetic shield 8 has a cross shape in plan view due to the cutouts 8a at the four corners, precision in positioning by the pressing portions 10a is also high. Due to this, the lid-portion magnetic shield 8 can be fixed so that when the case 3 is closed with the lid portion 4, two outer edges of the lid-portion magnetic shield 8 highly precisely form a right angle with respect to the sensitivity direction S (width direction of the bus bar 2) of the magnetic sensor 6. Therefore, it becomes hard for the magnetic flux passing through the lid-portion magnetic shield 8 to bend, making it possible to prevent measurement precision from becoming worse.

Furthermore, in the lid portion 4, hole portions 4a are formed by the pressing portions 10a of the first mold 10 at portions corresponding to the cutouts 8a of the lid-portion magnetic shield 8, as indicated in Fig. 7, in which the inner surface side of the lid portion 4 is indicated (the inner surface is on the inner side of the case 3 and is opposite to the circuit board 7). In the hole portion 4a in the lid portion 4, an exposed surface 8d exposed along the outer edges of the cutout 8a of the lid-portion magnetic shield 8 is formed.

The exposed surface 8d is formed when a step portion 10b formed on the pressing portion 10a of the first mold 10 abuts at an end along the cutout 8a, as indicated in Fig. 6. A melted resin flowing along the surface of the lid-portion magnetic shield 8 in the mold space C formed by the first mold 10 and second mold 11 attempts to enter a portion where the pressing portion 10a and an outer edge of the lid-portion magnetic shield 8 are in mutual contact. At this time, since the step portion 10b is in contact with a surface along the cutout 8a (the surface is the exposed surface 8d), the flow of the melted resin along the lid-portion magnetic shield 8 is blocked by the surface with which the step portion 10b is in contact (the surface is the exposed surface 8d).

Due to this, the melted resin does not enter the portion where the pressing portion 10a and the outer edge of the lid-portion magnetic shield 8 are in mutual contact, so burrs in a thin-plate shape are not formed along the outer edge of the lid-portion magnetic shield 8. Therefore, the molding quality of the lid portion 4 in which the lid-portion magnetic shield 8 is insert-molded is high, and it is possible to prevent burrs from coming off and becoming foreign matter.

Incidentally, in the current sensor 1 in this embodiment, a case-side magnetic shield 9 is buried in the bottom of the case 3 and the magnetic sensor 6 is placed between the lid-portion magnetic shield 8 and the case-side magnetic shield 9 by closing the case 3 with the lid portion 4, as indicated in Fig. 3. However, since the lid-portion magnetic shield 8 is provided, the case-side magnetic shield 9 may not be provided depending on the use environment such as the attachment position of the current sensor 1.

### Reference Signs List

- 1: current sensor
- 2: bus bar
- 3: case
- 4: lid portion
- 4a: hole portion
- 6: magnetic sensor
- 7: circuit board
- 8: lid-portion magnetic shield (magnetic shield)
- 8a: cutout
- 8B, 8b: protrusion portion
- 8c: caulking portion
- 8d: exposed surface (partial surface along the cutout)

## Claims

1. A current sensor (1) comprising:
a plurality of bus bars (2) formed from an electric conductor:
a plurality of magnetic sensors (6) that detect an induced magnetic field generated by a current flowing in each bus bar (2);
a circuit board (7) on which the magnetic sensors (6) are mounted;
a case (3) made of a synthetic resin, the case (3) fixing the bus bars (2) and the circuit board (7);
a lid portion (4), made of a synthetic resin, that houses the circuit board (7) together with the case (3); and
a magnetic shield (8) that is insert-molded in the lid portion (4);
**characterised in that**
the magnetic shield (8) has a plurality of cutouts (8a) along circumferential edges of the magnetic shield (8), and
hole portions (4a) are formed from which outer edges of the cutouts (8a) of the magnetic shield (8) are exposed.

2. The current sensor according to Claim 1, wherein:
the magnetic shield (8) has four edges oriented in different directions spaced at intervals of 90 degrees; and
the cutouts (8a) are provided at four corners of the magnetic shield (8).

3. The current sensor according to Claim 2, wherein each of the plurality of cutouts (8a) is formed in a quadrangular shape in plan view, the magnetic shield (8) is formed in a cross shape in plan view due to four protrusion portions (8B, 8b), each of which is a portion between adjacent cutouts (8a), and two protrusion portions (8B, 8b) positioned on one straight line protrude along a current direction of the bus bar (2).

4. The current sensor according to Claim 3, wherein:
in the magnetic shield (8), a plurality of plate-like magnetic bodies are stacked in a thickness direction and are integrally linked by a caulking portion (8c); and
the caulking portions (8c) are provided in the protrusion portions (8B, 8b) protruding along the current direction of the bus bar (2), in the magnetic shield (8) formed in a cross shape in plan view.

5. The current sensor according to any one of Claims 1 to 4, wherein a partial surface (8d) of the magnetic shield (8), the partial surface (8d) being along the cutout, is exposed.

## Patentansprüche

1. Stromsensor (1), aufweisend:
eine Mehrzahl von Stromsammelschienen (2), die aus einem elektrischen Leiter gebildet sind;
eine Mehrzahl von Magnetsensoren (6), die ein induziertes Magnetfeld erfassen, das durch einen Strom erzeugt wird, der in der jeweiligen Stromsammelschiene (2) fließt;
eine Leiterplatte (7), auf der die Magnetsensoren (6) angebracht sind;
ein aus Kunstharz hergestelltes Gehäuse (3), wobei das Gehäuse (3) die Stromsammelschienen (2) und die Leiterplatte (7) festlegt;
einen aus Kunstharz hergestellten Deckelbereich (4), der die Leiterplatte (7) zusammen mit dem Gehäuse (3) aufnimmt; und
eine magnetische Abschirmung (8), die in den Deckelbereich (4) durch Einsatzformen eingeformt ist;
**dadurch gekennzeichnet, dass** die magnetische Abschirmung (8) eine Mehrzahl von Ausschnitten (8a) entlang von Umfangsrändern der magnetischen Abschirmung (8) aufweist, und
dass Öffnungsbereiche (4a) gebildet sind, von denen äußere Ränder der Ausschnitte (8a) der magnetischen Abschirmung (8) freiliegen.

2. Stromsensor nach Anspruch 1,
wobei die magnetische Abschirmung (8) vier Kanten aufweist, die in unterschiedlichen Richtungen ausgerichtet sind und in Intervallen von 90 Grad beabstandet sind; und
wobei die Ausschnitte (8a) an vier Ecken der magnetischen Abschirmung (8) vorgesehen sind.

3. Stromsensor nach Anspruch 2,
wobei jeder der mehreren Ausschnitte (8a) in der Draufsicht viereckig ausgebildet ist, wobei die magnetische Abschirmung (8) aufgrund von vier Vorsprungbereichen (8B, 8b), bei denen es sich jeweils um einen Bereich zwischen benachbarten Ausschnitten (8a) handelt, in der Draufsicht kreuzförmig ausgebildet ist, und wobei zwei auf einer geraden Linie angeordnete Vorsprungbereiche (8B, 8b) entlang einer Stromrichtung der Stromsammelschiene (2) vorstehen.

4. Stromsensor nach Anspruch 3,
wobei in der magnetischen Abschirmung (8) eine Mehrzahl von plattenartigen magnetischen Körpern in Dickenrichtung gestapelt sind und durch einen Breitdrückbereich (8c) in integraler Weise verbunden sind; und
wobei in der magnetischen Abschirmung (8), die in der Draufsicht kreuzförmig ausgebildet ist, die Breitdrückbereiche (8c) in den Vorsprungbereichen (8B, 8b) vorgesehen sind, die entlang der Stromrichtung der Stromsammelschiene (2) vorstehen.

5. Stromsensor nach einem der Ansprüche 1 bis 4,
wobei eine entlang des Ausschnitts befindliche Teilfläche (8d) der magnetischen Abschirmung (8) freiliegt.

## Revendications

1. Capteur de courant (1) qui comprend :
un certain nombre de barres omnibus (2) qui sont réalisées à partir d'un conducteur électrique ;
un certain nombre de capteurs magnétiques (6) qui détectent un champ magnétique induit généré par une circulation de courant dans chaque barre omnibus (2) ;
une carte de circuits imprimés (7) sur laquelle sont montés les capteurs magnétiques (6) ;
un boîtier (3) réalisé à partir d'une résine synthétique, le boîtier (3) fixant les barres omnibus (2) et la carte de circuits imprimés (7) ;
une portion faisant office de couvercle (4), réalisée à partir d'une résine synthétique, qui fait office de logement pour la carte de circuits imprimés (7), au même titre que le boîtier (3) ; et
un blindage magnétique (8) qui est moulé par insertion dans la portion faisant office de couvercle (4) ;
**caractérisé en ce que**
le blindage magnétique (8) possède un certain nombre de découpes (8a) le long des bords circonférentiels du blindage magnétique (8) ; et
des portions sous la forme de trous (4a) sont réalisées, à partir desquelles les bords externes des découpes (8a) du blindage magnétique (8) sont exposés.

2. Capteur de courant selon la revendication 1, dans lequel :
le blindage magnétique (8) présente quatre bords qui sont orientés dans des directions différentes espacées par des intervalles de 90° ; et
les découpes (8a) sont prévues aux quatre coins du blindage magnétique (8).

3. Capteur de courant selon la revendication 2, dans lequel chacune desdites plusieurs découpes (8a) présente une configuration de forme rectangulaire dans une vue en plan, le blindage magnétique (8) présente une configuration en forme de croix dans une vue en plan sur la base de quatre portions (8B, 8b) sous la forme de protrusions, dont chacune représente une portion qui s'étend entre des découpes adjacentes (8a), et de deux portions (8B, 8b) sous la forme de protrusions, qui sont disposées sur une ligne droite, font saillie dans la direction du courant de la barre omnibus (2).

4. Capteur de courant selon la revendication 3, dans lequel :
dans le blindage magnétique (8), un certain nombre de corps magnétiques en forme de plaques sont empilés dans le sens de l'épaisseur et sont reliés pour former une seule pièce par l'intermédiaire d'une portion faisant office de calfeutrage (8c) ; et
les portions faisant office de calfeutrage (8c) sont prévues dans les portions (8B, 8b) sous la forme de protrusions qui font saillie dans la direction du courant de la barre omnibus (2), dans le blindage magnétique (8) qui présente une configuration en forme de croix dans une vue en plan.

5. Capteur de courant selon l'une quelconque des revendications 1 à 4, dans lequel une surface partielle (8d) du blindage magnétique (8), la surface partielle (8d) s'étendant le long de la découpe, est exposée.
